# EUROPÄISCHE PATENTSCHRIFT

(11) **EP 2 568 560 B1**
(45) Veröffentlichungstag und Bekanntmachung des Hinweises auf die Patenterteilung: **31.12.2014**
(21) Anmeldenummer: 11180307.8
(22) Anmeldetag: 07.09.2011
(51) Int. Cl.: H02H 7/12, G01R 31/02

(54) **Frequenzumrichter sowie Verfahren zum Erkennen und Blockieren eines Fehlerstroms in einem Frequenzumrichter**
Frequency inverter and method for detecting and blocking a residual current in a frequency inverter
Convertisseur de fréquence et procédé de reconnaissance et de blocage d'un courant de fuite dans un convertisseur de fréquence

(43) Veröffentlichungstag der Anmeldung: 13.03.2013
(73) Patentinhaber: Siemens Aktiengesellschaft, 80333 München (DE)
(72) Erfinder: Dillig, Reinhold, 96117 Memmelsdorf (DE); Herrmann, Bernd, 91074 Herzogenaurach (DE); Schierling, Hubert, 91052 Erlangen (DE); Weis, Benno, 91334 Hemhofen (DE)

(56) Entgegenhaltungen:
- EP-A2- 0 490 388
- WO-A1-93/03530
- GB-A- 2 309 597
- US-A- 4 870 527

## Beschreibung

Die Erfindung betrifft ein Verfahren zum Erkennen und gegebenenfalls Blockieren eines Fehlerstroms in einem Frequenzumrichter. Zu der Erfindung gehört auch Frequenzumrichter zum Erzeugen einer Wechselspannung mit vorgebbarer Wechselfrequenz aus einer Netzwechselspannung mit fester Wechselfrequenz. Der Frequenzumrichter umfasst einen Gleichrichter, einen Zwischenkreis und einen Wechselrichter. Mittels des Gleichrichters kann dabei aus der Netzwechselspannung eine Zwischenkreis-Gleichspannung und daraus wiederum mittels des Wechselrichters die Wechselspannung mit der vorgebbaren Wechselfrequenz erzeugt werden.

Mit einem Frequenzumrichter der genannten Art kann beispielsweise eine elektrische Maschine an einem elektrischen Versorgungsnetz betrieben werden. Mittels des Frequenzumrichters kann dabei in Statorwicklungen der Maschine ein Drehstrom erzeugt und hierbei eine Frequenz der Wechselspannungen der einzelnen Motorleitungen eingestellt werden. Dazu wird durch den Wechselrichter mittels Halbleiter-Leistungsschaltern aus der Gleichspannung des Zwischenkreises in jedem der Phasenleiter beispielsweise auf der Grundlage einer Pulsweitenmodulation sowohl die Frequenz als auch die Amplitude der Wechselspannung vorgegeben. Aufgrund der verwendeten Pulsweitenmodulation kann es zu betriebsmäßigen Ableitströmen kommen, d.h. zu Strömen, die nicht innerhalb des Netzes, sondern über ein Erd- oder Massepotential geschlossen werden. Die Ableitströme können dabei über eine kapazitive Kopplung zwischen der Anordnung aus dem Frequenzumrichter und der elektrischen Maschine einerseits und Gegenständen in deren Umgebung andererseits fließen.

Soll die Anordnung für einen Personen- und/oder Brandschutz über einen Fehlerstromschutzschalter betrieben werden können, kann sich das Problem ergeben, dass ein solcher Schutzschalter nicht zwischen einem wirklichen (beispielsweise durch ein beschädigtes Kabel verursachten) Fehlerstrom und einem betriebsmäßig erzeugten Ableitstrom unterscheiden kann.

In der WO 93/03530 A1, das den Oberbegriff der Ansprüche 1 und 7 bildet, ist eine Umrichteranordnung beschrieben, bei welcher frühzeitig Entladungsfehler erkannt werden. Hierzu wird in einem Gleichspannungs-Zwischenkreis der Umrichteranordnung ein Signal gewonnen und einer Frequenzanalyse unterzogen, um bei der Frequenzanalyse eine Erhöhung von nicht-charakteristischen harmonischen Signalanteilen im Frequenzspektrum und/oder eine Erhöhung von interharmonischen Signalanteilen im Frequenzspektrum zu betrachten. Diese Signalanteile sind bei Fehlern in der Umrichteranordnung erhöht und werden deshalb zur Fehleranalyse genutzt. Falls ein Fehler erkannt wird, kann eine Abschaltung der Umrichteranordnung erfolgen, indem Steuereinrichtungen eines Gleichrichters und eines Wechselrichters der Umrichteranordnung angesteuert werden.

In der US 4 870 527 A ist ein Frequenzumrichter mit einer Detektionseinrichtung für einen über eine Masse abfließende Fehlerstrom beschrieben. Es ist in einem Gleichspannungs-Zwischenkreis ein Fehlerstromdetektor bereitgestellt, der einen weichmagnetischen Ringkern aufweist.

In der GB 2 309 597 A ist ein Frequenzumrichter beschrieben, bei welchem eine Strommessung zum Erkennen eines Fehlerstroms in einem Gleichspannungs-Zwischenkreis des Frequenzumrichters durchgeführt wird. Liegt ein Fehlerstrom vor, so werden Transistoren des Wechselrichters im Frequenzumrichter in einen sperrenden Zustand geschaltet. Bei einem Durchbruch in einem der Transistoren des Wechselrichters wird ein Fehlersignal an eine Auswerteeinrichtung übertragen, welche in Abhängigkeit von einer Spannung, die dann über dem Transistor abfällt, den Wechselrichter abschaltet.

Es ist Aufgabe der vorliegenden Erfindung, den Einsatz eines Fehlerstromschutzschalters bei einem Frequenzumrichter zu ermöglichen.

Die Aufgabe wird durch das Verfahren gemäß Anspruch 1 sowie durch den Frequenzumrichter gemäß Anspruch 7 gelöst. Vorteilhafte Weiterbildungen der Erfindung sind durch die Unteransprüche gegeben.

Bei dem erfindungsgemäßen Verfahren wird zum Erkennen und gegebenenfalls Blockieren eines Fehlerstroms in einem Frequenzumrichter ein Verlauf einer Stromstärke eines über den Frequenzumrichter geführten Stroms ermittelt. In Abhängigkeit davon, wo im Frequenzumrichter der Verlauf ermittelt wird, wird für diesen ermittelten Verlauf ein Signalanteil vorgegeben, von welchem bekannt ist, dass er im fehlerfreien Betrieb des Frequenzumrichters abhängig von den Schaltvorgängen innerhalb des Frequenzumrichters ist. Bei dem Signalanteil kann es sich beispielsweise um ein bestimmtes Frequenzband handeln oder aber auch um bestimmte zeitliche Abschnitte innerhalb des Verlaufs. Um das Vorliegen eines Fehlerstroms zu erkennen, wird überprüft, ob bei dem ermittelten Verlauf ein in Abhängigkeit von diesem Signalanteil vorgegebenes Kriterium erfüllt. Ist dies der Fall, so wird der über den Frequenzumrichter geführte Strom unterbrochen. Welches Kriterium vorgegeben wird, hängt also davon ab, an welcher Stelle in dem Frequenzumrichter der Verlauf ermittelt wurde und welcher Signalanteil überwacht wird.

Das erfindungsgemäße Verfahren weist den Vorteil auf, dass sehr viel zuverlässiger zwischen einem betriebsbedingten Ableitstrom und einem unerwünschten Fehlerstrom unterschieden werden kann. Anstatt einen Fehlerstromschutzschalter netzseitig vor den Gleichrichter des Frequenzumrichters zu schalten, wie es im Stand der Technik üblich ist, wird zumindest das Ermitteln des Verlaufs der Stromstärke an dedizierte Stellen innerhalb des Umrichters verlagert, an welchen eine sichere Unterscheidung zwischen einem Ableitstrom einerseits und einem Fehlerstrom andererseits möglich ist.

Der ebenfalls zur Erfindung gehörige Frequenzumrichter weist einen hierzu entsprechenden Aufbau auf. Er umfasst wenigstens die bereits genannten drei Komponenten, nämlich einen Gleichrichter, einen Zwischenkreis und einen Wechselrichter. Wenigstens eine der Komponenten weist dabei eine Messeinrichtung zum Messen einer Stromstärke eines Gleichtaktstromes (Englisch: Common mode current) auf. Durch die Messeinrichtung ist ermöglicht, den Verlauf einer Stromstärke eines Differenzstroms zwischen wenigstens zwei elektrischen Leitern des Frequenzumrichters zu ermitteln. Dadurch ergibt sich der Vorteil, dass auch bei hohen Spannungen verhältnismäßig kleine Stromstärken genau gemessen werden können. Mit einer Differenzstrommessung ist hierbei eine Gleichtaktstrommessung (Common-Mode-Strommessung) gemeint. Die Messung eines zum Teil unter 15 mA großen Ableitstroms ist somit auch bei einer Maximalamplitude der Spannung von bis zu mehreren hundert Volt möglich. Bevorzugt weist der erfindungsgemäße Frequenzumrichter auch gleich selbst eine Auswerteinheit auf, mittels welcher eine Ausführungsform des erfindungsgemäßen Verfahrens durchgeführt werden kann.

Eine Aufteilung des Verlaufs in Zeitabschnitte, während welcher das Kriterium zu prüfen ist, und Zeitabschnitte, während welcher ein Ableitstrom zu erwarten ist und deshalb die Fehlerüberprüfung unterbleibt, erfolgt gemäß dem erfindungsgemäßen Verfahren dadurch, dass ein Schaltsignal für Halbleiter-Leistungsschalter des Frequenzumrichters überwacht wird und abhängig von dem überwachten Schaltsignal ein Zeitabschnitt des ermittelten Verlaufs der Stromstärke auf das Kriterium hin untersucht wird. Hierdurch ergibt sich der Vorteil, dass keine gesonderte Messung zum Bestimmen der geeigneten Zeitabschnitte nötig ist, da in dem Schaltsignal bereits alle Informationen enthalten sind.

Eine entsprechende Ausführungsform des erfindungsgemäßen Frequenzumrichters sieht eine Auswerteeinrichtung vor, die mit einer Messeinrichtung zum Messen des Stromstärke-Verlaufs einerseits und mit einer Steuereinrichtung zum Steuern von Halbleiter-Leistungsschaltern des Wechselrichters bzw. des Gleichrichters gekoppelt ist. In dieser Auswerteeinrichtung sind dann sämtliche Informationen für eine genaue Analyse des Stromstärke-Verlaufs verfügbar.

Eine weitere Möglichkeit der Erkennung der Schaltzeitpunkte von Halbleiter-Leistungsschaltern ist gemäß einer anderen Ausführungsform des erfindungsgemäßen Frequenzumrichters gegeben, indem der Wechselrichter eine Spannungsmesseinrichtung zum Messen eines Verlaufs der von dem Wechselrichter erzeugten Wechselspannungen aufweist, die kapazitiv mit der Leitungseinrichtung für die Wechselspannungen gekoppelt ist. Diese Ausführungsform weist den Vorteil auf, dass keine Verbindung mit der Steuereinrichtung für die Halbleiter-Leistungsschalter nötig ist.

Eine einfache und robuste Messeinrichtung zum Erfassen eines Stromstärke-Verlaufs ist gegeben, wenn ein weichmagnetischer Ringkern bei der Messeinrichtung vorgesehen ist. Mit diesem lässt sich die Messeinrichtung auch auf einfache Weise galvanisch von dem Rest des Frequenzumrichters trennen. Mittels eines Ringkerns werden dabei bei einem dreiphasigen System die drei spannungsführenden Leitungen (bei einem zweiphasigen System entsprechend die beiden spannungsführenden Leitungen) durch einen gemeinsamen Ringkern geführt. Auf dem Ringkern ist eine zusätzliche Wicklung aufgebracht, an welcher dann eine der Stromstärke des Differenzstroms der Leitungen proportionale Spannung gemessen werden kann. Alternativ kann zum Messen in bekannter Weise auch ein Kompensationswandler verwendet werden.

Bei einer Ausführungsform des erfindungsgemäßen Verfahrens ist vorgesehen, dass als Signalanteil zumindest ein spektrales Band vorgegeben wird. Mit anderen Worten werden in einem Spektrum des Verlaufs bestimmte Frequenzen daraufhin untersucht, ob sie ein entsprechend vorgegebenes Kriterium erfüllen. Hierdurch ist es beispielsweise möglich, bei einem netzgeführten Gleichrichter einen Erdschluss in dem Zwischenkreis daran zu erkennen, dass ein im Gleichrichter erfasster Gleichtaktstrom einen Signalanteil zwischen 130-Hz und 200 Hz, insbesondere einen 150 Hz-Signalanteil oder 180 Hz-Signalanteil, aufweist. Erdschlussfehler auf dem Zwischenkreis können wegen eines ausgeprägten 150 Hz-Anteils (im 50 Hz-Wechselstromnetz, 180 Hz im 60 Hz-Netz) durch eine Frequenzbereichsanalyse sehr deutlich von einem betriebsmäßigen Ableitstrom unterschieden werden, der sich z.B. 4 kHz-Anteile aufweisen kann. Unter einem Erdschluss ist im Zusammenhang mit der Erfindung eine elektrische Kopplung (galvanisch) zwischen der Anordnung aus dem Frequenzumrichter und einem mit diesem betriebenen elektrischen Gerät einerseits und der Umgebung andererseits gemeint, über die unabhängig von den Schaltvorgängen im Frequenzumrichter ein Strom aus der Anordnung in die Umgebung abfließen kann, dessen Stromstärke eine Person gefährden oder einen Brand auslösen kann.

Um eine solche Messung eines Erdschlusses zu ermöglichen, ist bei einer Ausführungsform des erfindungsgemäßen Frequenzumrichters vorgesehen, dass dessen Gleichrichter einen Stromwandler aufweist, der mit einer Leitungseinrichtung für die Netzwechselspannung gekoppelt ist, die zwischen einem Netzwechselspannungseingang des Gleichrichters und Halbleiter-Leistungsschalter desselben angeordnet ist. Mit anderen Worten findet die Gleichtaktstrommessung netzseitig vor den Leistungsschaltern des Gleichrichters statt. Hierdurch ist ein Fehlerschutz für Erdschlüsse im Gleichspannungszwischenkreis des Frequenzumrichters gegeben.

Eine andere Ausführungsform des erfindungsgemäßen Frequenzumrichters sieht vor, dass dessen Wechselrichter eine Messeinrichtung der genannten Art aufweist und hierbei mittels eines Stromwandlers der Messeinrichtung ein Gleichtaktstrom in einer Wechselspannungs-Leitungseinrichtung für die (ausgangsseitige) Wechselspannungen gekoppelt ist. Mit anderen Worten ist hier eine Gleichtaktstrommessung auf der Wechselspannungsseite der Leistungsschalter des Wechselrichters vorgesehen. Hierdurch wird ein Schutz vor Erdschlüssen auf Motorleitungen oder in einer elektrischen Maschine ermöglicht, die über den Wechselrichter betrieben wird. Zudem können Fehlerströme innerhalb der Maschine erkannt werden.

Eine weitere Ausführungsform des erfindungsgemäßen Verfahrens sieht hierbei vor, dass bei dem ermittelten Verlauf der Stromstärke als zu überprüfender Signalanteil zumindest ein Zeitabschnitt vorgegeben wird. Hier kommt der Vorteil zum Tragen, dass z.B. aus den Ansteuersignalen für den Wechselrichter jederzeit der Verlauf des betriebsbedingten Ableitstroms ermittelt werden kann. Für jeweils die Zeitdauer der (durch die Schaltvorgänge des Wechselrichters verursachten) Spannungsänderung in der Wechselspannungs-Leitungseinrichtung kann ein gemessener Gleichtaktstrom als betriebsmäßig plausibel akzeptiert und damit eine Fehlauslösung verhindert werden. Ist die Spannungsänderung inklusive einer Zeitreserve abgelaufen und wird immer noch ein Gleichtaktstrom gemessen, so wird dagegen ein Fehler angenommen und eine Schutzeinrichtung ausgelöst. Mit anderen Worten werden Signaländerungen während der Schaltphasen der Leistungsschalter inklusive einer Zeitreserve ausgeblendet, da hier ein Ableitstrom zu erwarten ist. Für den Fall, dass mittels des Gleichrichters des Frequenzumrichters eine aktive Netzgleichrichtung betrieben wird, wenn der Gleichrichter also z.B. als Hochsetzsteller betrieben wird, ist auch bei dem Gleichrichter eine Fehlerstromerkennung durch Vorgeben von zumindest einem Zeitabschnitt als zu analysierendem Signalanteil möglich.

In Bezug auf das Unterbrechen des Stroms bei erkanntem Fehlerstrom sieht eine Ausführungsform des erfindungsgemäßen

Verfahrens vor, Pulse eines Wechselrichters, über welchen der Strom geführt wird, zu unterdrücken. Der Begriff Pulse bezieht sich hierbei auf die Schaltsignale für die Halbleiter-Leistungsschalter des Wechselrichters. Diese Ausführungsform des Verfahrens weist den Vorteil auf, dass kein zusätzlicher Schalter vorgesehen werden muss, um den Fehlerstrom zu blockieren. Indem lediglich die Pulse desjenigen Wechselrichters unterdrückt werden, über welchen der Fehlerstrom fließt, bleiben zudem der Gleichrichter und der Zwischenkreis zum Betreiben weiterer Wechselrichter nutzbar.

Eine andere Ausführungsform des erfindungsgemäßen Verfahrens sieht vor, dass zum Unterbrechen des Stromes der gesamte Frequenzumrichter von dem Einspeisenetz abgekoppelt wird, welches die Quelle des über den Frequenzumrichter geführten Stromes bildet. Hierbei ergibt sich der Vorteil, dass eine bereits standardmäßig vorhandene Schalteinrichtung (wie zum Beispiel ein Schütz) oder eine Schalteinrichtung eines dem Gleichrichter netzseitig vorgeschalteten Schutzschalters zum Abkoppeln des Frequenzumrichters genutzt werden kann.

Für den Fall, dass dem Gleichrichter auch netzseitig ein Fehlerstromschutzschalter vorgeschaltet werden soll, sieht eine Ausführungsform des erfindungsgemäßen Frequenzumrichters vor, dass dieser Fehlerstromschutzschalter durch eine Bandbegrenzung ein niederfrequentes Auslösespektrum aufweist und hierdurch nur bei Fehlerströmen mit einer Wechselfrequenz von weniger als 150 Hz, insbesondere weniger als 100 Hz, der Strom durch diesen Fehlerstromschutzschalter unterbrochen wird. Mit dem erfindungsgemäßen Frequenzumrichter ist somit möglich, dem Gleichrichter netzseitig einen Standard-Fehlerstromschutzschalter vorzuschalten, der aber dank der Bandbegrenzung nicht ungewollt durch einen Ableitstrom ausgelöst wird, wie er durch die Schaltvorgänge innerhalb des Frequenzumrichters entstehen kann.

Im Zusammenhang mit einem dem Gleichrichter netzseitig vorgeschalteten Fehlerstromschutzschalter mit Bandbegrenzung ergibt sich ein weiterer Vorteil, wenn zusätzlich als EMV-Filter für den Frequenzumrichter ein ableitstromarmes Filter dem Gleichrichter netzseitig vorgeschaltet ist. Ein solches Filter verursacht im bestimmungsgemäßen Betrieb des Frequenzumrichters nur einen betriebsmäßigen Ableitstrom, welcher kleiner als eine Auslösestromstärke des vorgeschalteten Fehlerstromschutzschalters ist. Hierdurch ist dann in vorteilhafter Weise eine weitere Quelle für Fehlauslösungen des dem Gleichrichter netzseitig vorgeschalteten Fehlerstromschutzschalters beseitigt.

Zu den im Zusammenhang mit dem erfindungsgemäßen Verfahren beschriebenen Weiterbildungen sind entsprechende Weiterbildungen des erfindungsgemäßen Frequenzumrichters ebenfalls von der Erfindung mit umfasst, ohne dass sie hier noch einmal gesondert beschrieben sind. Entsprechendes gilt auch für die beschriebenen Weiterbildungen des erfindungsgemäßen Frequenzumrichters, zu denen entsprechende Weiterbildungen des erfindungsgemäßen Verfahrens ebenfalls von der Erfindung mit umfasst sind, ohne dass sie hier noch einmal gesondert beschrieben sind.

Die Erfindung wird im Folgenden anhand eines Ausführungsbeispiels näher erläutert. Dazu zeigt:
- FIG 1: ein Blockschaltbild zu einem Frequenzumrichter gemäß einer Ausführungsform des erfindungsgemäßen Frequenzumrichters,
- FIG 2: ein Diagramm mit einem zeitlichen Verlauf eines Gleichtaktstromes, der gemäß einer Ausführungsform des erfindungsgemäßen Verfahrens in einem Wechselrichter des Frequenzumrichters von FIG 1 gemessen wurde,
- FIG 3: ein Diagramm mit einem zeitlichen Verlauf eines Gleichtaktstromes, der gemäß einer Ausführungsform des erfindungsgemäßen Verfahrens in einem Gleichrichter des Frequenzumrichters von FIG 1 gemessen wurde, und
- FIG 4: ein Diagramm mit einem zeitlichen Verlauf eines Gleichtaktstromes, der gemäß einer Ausführungsform des erfindungsgemäßen Verfahrens in einem dem Gleichrichter von FIG 1 netzseitig vorgeschalteten Fehlerstromschutzschalter gemessen wurde.

Das Ausführungsbeispiel stellt eine bevorzugte Ausführungsform der Erfindung dar.

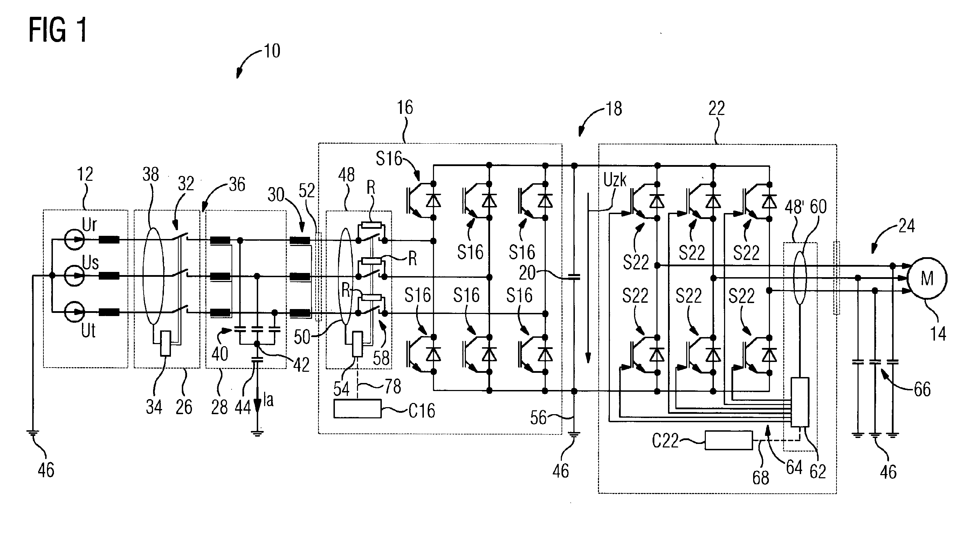

In FIG 1 ist ein Frequenzumrichter 10 gezeigt, welcher an ein elektrisches Drehstrom-Versorgungsnetz 12 angeschlossen ist. Netzwechselspannungen oder Sternspannungen Ur, Us, Ut des Versorgungsnetzes 12 weisen in dem Beispiel einen Effektivwert von 230 V und eine Wechselfrequenz von 50 Hz auf. Über den Frequenzumrichter 10 wird an dem Versorgungsnetz 12 eine elektrische Maschine 14 als Elektromotor betrieben.

Für den Betrieb der elektrischen Maschine 14 erzeugt ein Gleichrichter 16 des Frequenzumrichters 10 aus den Sternspannungen Ur, Us, Ut in einem Zwischenkreis 18 eine gleichgerichtete Zwischenkreisspannung Uzk, die von einem Glättungskondensator 20 geglättet wird. Aus der Zwischenkreisspannung Uzk erzeugt ein Wechselrichter 22 in Motorleitungen 24 phasenversetzte Wechselspannungen mit einer Wechselfrequenz und einem Effektivwert, die beide mittels des Wechselrichters 22 eingestellt werden. Die Motorleitungen 24 stellen eine Leitungseinrichtung für die von dem Wechselrichter 22 erzeugten Wechselspannungen dar.

Neben dem Wechselrichter 22 kann der Frequenzumrichter 10 noch weitere (nicht dargestellte) Wechselrichter aufweisen, über welche entsprechend weitere elektrische Maschinen an dem Zwischenkreis 18 betrieben werden können.

Zum Erzeugen der Zwischenkreisspannung Uzk aus den Sternspannungen Ur, Us, Ut weist der Gleichrichter 16 Halbleiter-Leistungsschalter S16 auf, die hier jeweils eine Parallelschaltung aus einem IGBT (insulated-gate bipolar transistor) und einer Diode umfassen. Steuerleitungen für die IGBTs, über welche Schaltimpulse einer Steuereinheit C16 des Gleichrichters 16 übertragen werden, sind in FIG 1 nicht dargestellt.

Der Wechselrichter 22 weist ebenfalls Halbleiter-Leistungsschalter S22 auf, mittels welchen eine Steuereinheit C22 des Wechselrichters 22 aus der Zwischenkreisgleichspannung Uzk die Wechselspannungen in den Motorleitungen 24 erzeugt. Die Halbleiter-Leistungsschalter S22 weisen dieselbe Bauweise auf wie die Halbleiter-Leistungsschalter S16. Steuerleitungen, über welche die Steuereinheit C22 IGBTs der Halbleiter-Leistungsschalter S22 steuert, sind in FIG 1 ebenfalls nicht dargestellt.

Dem Gleichrichter 16 sind netzseitig, das heißt zum Versorgungsnetz 12 hin, ein Fehlerstromschutzschalter 26, ein EMV-Filter 28 sowie Kommutierungsdrosseln 30 vorgeschaltet.

Mit dem Fehlerstromschutzschalter 26 kann ein vom Versorgungsnetz 12 in den Frequenzumrichter 10 fließender Strom durch ein Schütz 32 unterbrochen werden. Das Schütz 32 wird durch eine Auswerteeinheit 34 des Fehlerstromschutzschalters 26 immer dann unterbrochen, wenn eine Stromstärke eines Gleichtaktstroms, der als Differenzstrom zwischen Netzphasenleitern 36 des Versorgungsnetzes 12 ermittelt wird, einen vorbestimmten Grenzwert überschreitet. Zum Messen des Gleichtaktstroms weist der Fehlerstromschutzschalter 26 einen Ringkern 38 mit einer Spule auf. Der Fehlerstromschutzschalter 26 ist vom Typ A, d.h. das mittels der Spule des Ringkerns 38 erfasste Differenzstromsignal wird durch einen Tiefpass gefiltert, so dass nur Signalanteile des Differenzstromsignals bis zu einer Frequenz von 100 Hz von der Auswerteeinheit 34 ausgewertet werden.

Das EMV-Filter 28 umfasst eine Sternschaltung 40 aus Filterkondensatoren, deren Sternpunkt 42 über einen Erdungskondensator 44 mit einem Erdpotential 46 kapazitiv gekoppelt ist. Ein über den Erdungskondensator 44 zum Erdpotential 46 hin abfließender Ableitstrom Ia weist eine derart geringe Stromstärke auf, dass der Fehlerstromschutzschalter 26 nicht auslöst. Dazu wurden als Filterkondensatoren der Sternschaltung 40 solche Kondensatoren gewählt, die eine möglichst ähnliche Kapazität aufweisen. Zusätzlich wurde die Kapazität des Erdungskondensators 44 möglichst klein gewählt.

Der Frequenzumrichter 10 weist zwei weitere Fehlerstromschutzschalter auf. Ein Fehlerstromschutzschalter 48 ist in den Gleichrichter 16, ein Fehlerstromschutzschalter 48' ist in den Wechselrichter 22 integriert.

Der Fehlerstromschutzschalter 48 weist einen Ringkern 50 auf, der die Netzphasenleiter 36 umgibt. Der Ringkern 50 ist zwischen einen Wechselspannungseingang 52 des Gleichrichters 16 und die Leistungsschalter S16 geschaltet. Ein Signal einer Spule des Ringkerns 50 wird von einer Auswerteeinheit 54 des Fehlerstromschutzschalters 48 überwacht. Anhand des Signals wird von der Auswerteeinheit 54 erkannt, ob in dem Zwischenkreis 48 ein Erdschluss 56 vorliegt. Die Auswerteeinheit 54 führt eine Ausführungsform des erfindungsgemäßen Verfahrens durch. Ein Erdschlussfehler auf dem Zwischenkreis ist wegen seines ausgeprägten 150 Hz-Signalanteils durch eine Frequenzbereichsanalyse des Signals der Spule des Ringkerns 50 sehr deutlich von einem betriebsmäßigen Ableitstrom zu unterscheiden, wie er beispielsweise durch eine kapazitive Kopplung des Zwischenkreises 18 mit dem Erdpotential 46 hervorgerufen werden kann, während die Halbleiter-Leistungsschalter S16 oder S22 geschaltet werden. Eine Gleichtaktstrommessung, wie sie durch den Ringkern 50 ermöglicht ist, kann auch im Zwischenkreis 18 selbst erfolgen.

Bei Erkennen eines Erdschlusses öffnet die Auswerteeinheit 54 ein Schütz 58 des Fehlerstromschutzschalters 48. Bei geöffnetem Schütz 58 ist eine Aufladung des Glättungskondensators 20 über Vorladewiderstände R des Fehlerstromschutzschalters 48 weiterhin möglich. Alternativ zu den Vorladewiderständen R kann jeweils ein zusätzliches Längsschütz vorgesehen sein.

Der Fehlerstromschutzschalter 48' des Wechselrichters 22 weist einen Ringkern 60 auf, welcher die Motorleitungen 24 umgibt. Ein Signal einer Spule des Ringkerns 60 wird von einer Auswerteeinheit 62 des Fehlerstromschutzschalters 48' verarbeitet. Die Auswerteeinheit 62 führt eine Ausführungsform des erfindungsgemäßen Verfahrens durch. Die durch den Ringkern 60 durchgeführte Gleichtaktstrommessung hinter den Leistungsschaltern S22 des Wechselrichters 22 dient zum Schutz vor Fehlerströmen und Erdschlüssen auf den Motorleitungen 24 und in der elektrischen Maschine 14. Die Auswerteeinheit 62 blockiert bei Erkennen eines Fehlers über entsprechende Signalleitungen 64 die an die Leistungsschalter S22 von der Steuereinheit C22 ausgesendeten Steuerpulse für die Leistungsschalter S22. Alternativ kann über einen netzseitigen Leistungsschalter, wie beispielsweise das Schütz 32, eine Abkopplung des gesamten Frequenzumrichters 10 vom Versorgungsnetz 12 erreicht werden.

Um in dem Signal der Spule des Ringkerns 60 einen Fehlerstrom von einem betriebsbedingten Ableitstrom, wie er beispielsweise durch eine kapazitive Kopplung 66 der Motorleitungen 24 mit dem Erbpotential 46 verursacht werden kann, unterscheiden zu können, wertet die Auswerteeinheit 62 den Zeitverlauf der Wechselspannungen der Motorleitungen 24 aus. Hierbei kann vorgesehen sein, dass die Auswerteeinheit 62 mit der Steuereinheit C22 über eine Signalleitung 68 gekoppelt ist, über welche die Auswerteeinheit 62 das Ansteuersignal für die Leistungsschalter S22 von der Steuereinheit C22 empfängt. Jeweils für die Zeitdauer der Spannungsänderung, wie sie durch Schalten der Leistungsschalter S22 in den Motorleitungen 24 verursacht werden, inklusive einer Zeitreserve wird von der Auswerteeinheit 62 ein mittels des Ringkerns 60 gemessener Gleichtaktstrom als betriebsbedingter Ableitstrom gewertet. Zwischen diesen Schaltflanken überprüft die Auswerteeinheit 62 allerdings das Kriterium, ob weiterhin ein Gleichtaktstrom vorliegt. Ist dies der Fall, so wird von einem Fehler in den Motorleitungen 24 oder in der elektrischen Maschine 14 ausgegangen.

Insgesamt ist somit bei dem Frequenzumrichter 10 sowohl durch eine frequenzselektive Auswertung des Signals der Spulen der Ringkerne 38 und 50 als auch durch eine zeitenselektive Auswertung des Signals der Spule des Ringkerns 60 eine zuverlässige Unterscheidung zwischen einem betriebsbedingten Ableitstrom einerseits und unerwünschten Fehlerströmen andererseits ermöglicht. Indem für Messungen an unterschiedlichen Orten des Frequenzumrichters 10 geeignete Kriterien für die Auswertung der Signale der Ringkerne vorgegeben werden, ist stets eine entsprechende Plausibilitätskontrolle für die Signale möglich. Welche Kriterien hierbei geeignet sind, kann durch Simulationen oder durch Messversuche einfach ermittelt werden.

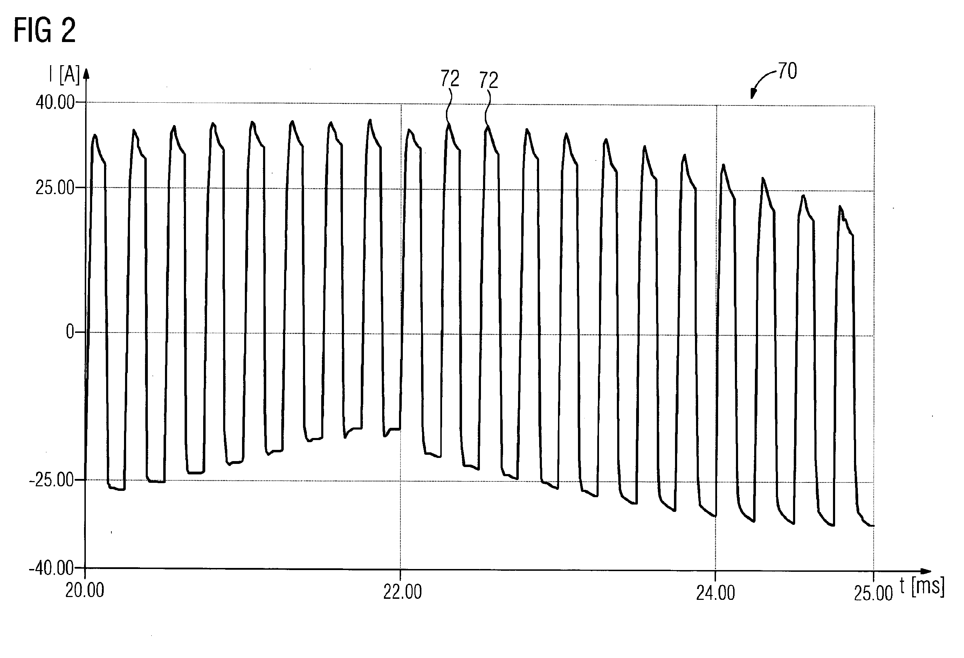

Im Folgenden wird hierzu anhand von FIG 2 bis FIG 4 noch einmal veranschaulicht, welche Signale sich in den Spulen der Ringkerne 38, 50, 60 bei unterschiedlichen Erdschlussfehlern über der Zeit t (in Millisekunden) ergeben. Als Ordinaten der Diagramme sind jeweils der gemessene Gleichtaktstrom in Ampere angegeben.

In FIG 2 ist ein Verlauf 70 eines Signals der Spule des Ringkerns 60 bei einem Erdschlussfehler auf einer der Motorleitungen 24 oder in der elektrischen Maschine 14 gezeigt. Der Verlauf weist einzelne Schaltspitzen 72 auf, von denen in FIG 2 der Übersichtlichkeit halber nur zwei mit einem Bezugszeichen versehen sind. Die einzelnen Schaltspitzen 72 werden durch Umladevorgänge auf den Motorleitungen 24 erzeugt, welche einen Ableitstrom über die kapazitive Kopplung 66 verursachen. Für die Zeitdauer einer Schaltspitze 72 wird ein Wert des Verlaufs 70 durch die Auswerteeinheit 62 nicht daraufhin überprüft, ob sein Betrag über einem vorgegebenen Schwellwert liegt. Zwischen den einzelnen Schaltspitzen 72 weist der Verlauf 70 einen Betrag auf, der sich nicht durch die Schaltvorgänge der Leistungsschalter S22, sondern durch den Erdschluss ergibt. Insgesamt ergibt sich dadurch ein blockförmiger Verlauf 70, also eine Abfolge von nahezu rechteckigen Impulsen. Ohne den Erdschluss würde der Verlauf 70 ausschließlich (nahezu Diracstoß-förmige) Schaltspitzen aufweisen. Aufgrund des Erdschlusses ist der Betrag des Verlaufs unmittelbar nach dem Auftreten einer jeden Schaltspitze 72 damit größer. Dies wird von der Auswerteeinheit 62 auf der Grundlage eines als Überprüfungskriterium verwendeten Schwellwerts erkannt, den der Betrag des Verlaufs 70 nach jeder Schaltspitze 72 überschreitet. Sie schaltet daraufhin die Leistungsschalter S22 in einen sperrenden Zustand, indem sie die Schaltpulse der Steuereinheit C22 unterdrückt.

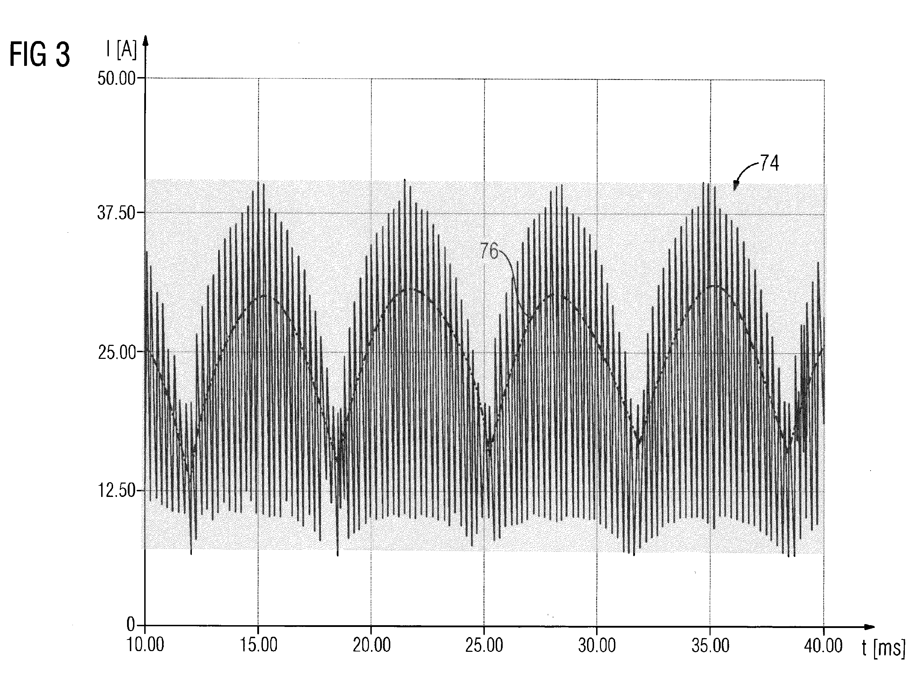

In FIG 3 ist ein Verlauf 74 eines Signals der Spule des Ringkerns 50 gezeigt, wie es sich bei einem Erdschlussfehler im Zwischenkreis 18 ergibt. Neben einzelnen Schaltspitzen, die durch Schaltvorgänge im Gleichrichter 16 verursacht werden, weist der Verlauf 64 einen von der Auswerteeinheit 54 mithilfe eines Bandpassfilters erkannten 150 Hz-Signalanteil 76 auf. Dieser Anteil ist durch den Erdschluss verursacht. Die Auswerteeinheit 54 erzeugt daher ein Signal, durch welches das Schütz 58 geöffnet wird. Die Auswertung des Verlaufs 74 kann bei der Auswerteeinheit 54 auch auf zeitliche Abschnitte beschränkt sein, die zwischen den einzelnen Schaltspitzen liegen. Dazu kann die Auswerteeinheit 54 über eine Signalleitung 78 mit der Steuereinheit C16 verbunden sein.

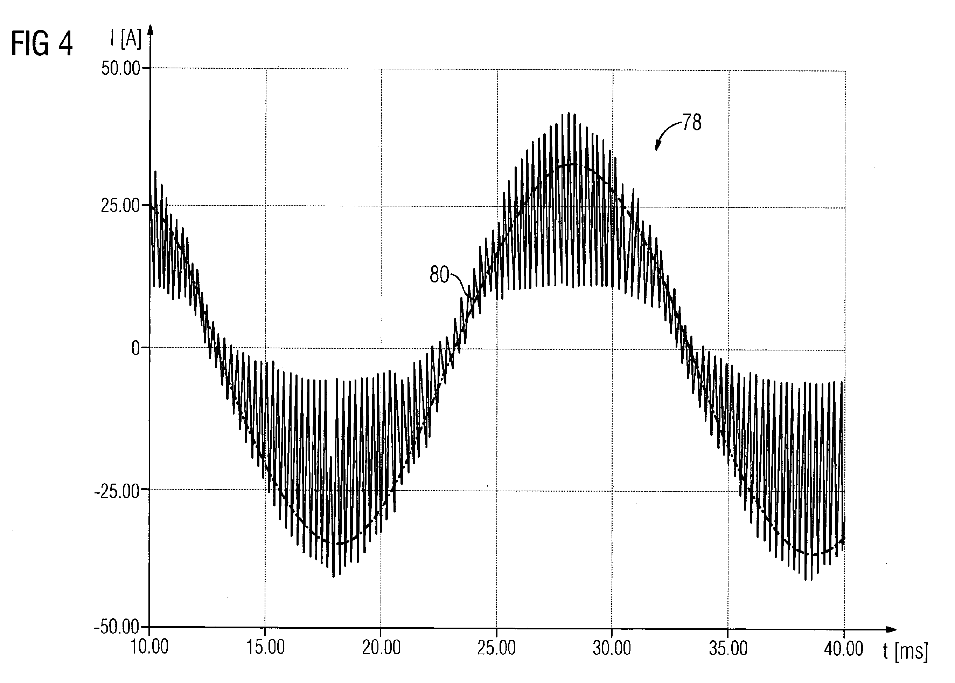

In FIG 4 ist ein Verlauf 78 des Signals der Spule des Ringkerns 38 gezeigt, wie es sich bei einem Erdschluss der Netzphasenleiter 36 ergibt. Durch das Tiefpassfilter des Fehlerstromschutzschalters 26 werden einzelne Schaltspitzen des Verlaufs 78, die durch Schaltvorgänge der Leistungsschalter S16 des Gleichrichters 16 verursacht werden, herausgefiltert. An einem nach der Filterung verbleibenden 50 Hz-Signalanteil 80 erkennt die Auswerteeinheit 34 den Erdschluss. Sie öffnet daraufhin das Schütz 32.

Durch das Beispiel ist gezeigt, wie ein Schutz vor Erzschlüssen auf Motorleitungen und in Motoren bereitgestellt und dabei eine im Motormodul (Wechselrichter 22) integrierte Überwachungsfunktion dazu genutzt werden kann, den betriebsmäßigen Ableitstrom, wie er aufgrund von Schaltflanken des Wechselrichters 22 entsteht, auszublenden. Eine Gleichtaktstrommessung in der Einspeiseeinheit (Gleichrichter 16) sorgt für einen Schutz vor Erdschlüssen auf dem Zwischenkreis und in den Motorleitungen. Dabei konzentriert sich der Fehlerschutz auf Signalanteile, die durch die Gleichrichtung der Netzspannungen entstehen, d.h. der Fehlerschutz sucht zum Beispiel gezielt nach Ableitstromanteilen mit einem spektralen Signalanteil von 150 Hz bzw. nach Schaltflanken, die durch eine aktive Netzgleichrichtung entstehen. Komplettiert wird dieses Schutzkonzept durch einen netzseitigen Fehlerstromschutzschalter vom Typ A. Dieser wird bewusst so gewählt, dass er gegenüber betriebsmäßigen Ableitströmen und Fehlerströmen im Pulsfrequenzbereich "blind" ist. Dies wird hier durch einen Tiefpass bewirkt. Die erforderliche Schutzfunktion für Pulsfrequenzanteile ist hierbei ja bereits in den Wechselrichtern integriert.

Durch diese Maßnahme kann netzseitig ein Fehlerstromschutzschalter mit Bandbegrenzung (Tiefpassfilter) eingesetzt werden. Dieser wird durch einen betriebsmäßigen Ableitstrom des Frequenzumrichters nicht mehr ausgelöst, da Störungen, wie sie durch Schalten der Leistungsschalter S16, S22 verursacht werden, in der Frequenz über der Bandbegrenzung liegen. Somit bleibt lediglich ein Ableitstrom, der durch Unsymmetrien in der Netzspannung und in Filterkondensatoren eines EMV-Filters entstehen kann. Hier besteht die Möglichkeit, ein ableitstromarmes Filter mit niedriger Erdkapazität einzusetzen, dessen Ableitstrom bei gleicher Unsymmetrie der Netzspannungen geringer ist als derjenige eines herkömmlichen EMV-Filters. Da hier nicht mehr zwangsweise eine große Erdkapazität eingesetzt werden muss, um den betriebsmäßigen Ableitstrom hoher Frequenz im Frequenzumrichter zu schließen, ist der Einsatz ableitstromarmer Filter problemlos möglich.

Die Verwendung eines bandbegrenzten Fehlerstromschutzschalters ist durch die Verlagerung einiger Überwachungsfunktionen aus dem netzseitigen Fehlerstromschutzschalter heraus in den Gleichrichter bzw. den Wechselrichter ermöglicht. Diese haben Informationen bezüglich der Zeitpunkte der Schaltflanken sowie der Spannungsform der Zwischenkreisspannung, mit deren Hilfe einfach zwischen möglichen Fehlern und betriebsmäßigen Ableitströmen unterschieden werden kann.

## Patentansprüche

1. Verfahren zum Erkennen und gegebenenfalls Blockieren eines Fehlerstroms in einem Frequenzumrichter (10), mit den Schritten:
- Ermitteln eines Verlaufs (70,74,78) einer Stromstärke eines über den Frequenzumrichter (10) geführten Stroms;
- für den ermittelten Verlauf (70,74,78), Vorgeben eines Signalanteils (76,80), welcher im fehlerfreien Betrieb des Frequenzumrichters unabhängig von Schaltvorgängen innerhalb des Frequenzumrichters ist,
- Überprüfen, ob der ermittelte Verlauf (70,74,78) ein in Abhängigkeit von dem Signalanteil (76,80) vorgegebenes Kriterium erfüllt, und gegebenenfalls Unterbrechen des Stromes,
**dadurch gekennzeichnet, dass** ein Schaltsignal für Halbleiter-Leistungsschalter (S16,S22) des Frequenzumrichters (10) überwacht wird und abhängig von dem überwachten Schaltsignal wenigstens ein Zeitabschnitt des ermittelten Verlaufs (70,74) der Stromstärke auf das Kriterium hin untersucht wird.

2. Verfahren nach Anspruch 1, **dadurch gekenn**- **zeichnet** , dass der Verlauf (70,74,78) einer Stromstärke eines Differenzstroms zwischen wenigstens zwei Phasenleitern (24,36) des Frequenzumrichters (10) ermittelt wird.

3. Verfahren nach Anspruch 1 oder 2, **dadurch ge**- **kennzeichnet**, dass als Signalanteil (76,80) zumindest ein spektrales Band vorgegeben wird.

4. Verfahren nach einem der vorhergehenden Ansprüche, d a - **durch gekennzeichnet** , dass als Signalanteil zumindest ein Zeitabschnitt vorgegeben wird.

5. Verfahren nach einem der vorhergehenden Ansprüche, d a - **durch gekennzeichnet**, dass zum Unterbrechen des Stromes Pulse eines Wechselrichters (22), über welchen der Fehlerstrom fließt, unterdrückt werden.

6. Verfahren nach einem der vorhergehenden Ansprüche, **da** - **durch gekennzeichnet** , dass zum Unterbrechen des Stromes der Frequenzumrichter (10) von einem Einspeisenetz (12) abgekoppelt wird, welches die Quelle des Stromes bildet.

7. Frequenzumrichter (10) zum Erzeugen einer Wechselspannung mit vorgebbarer Wechselfrequenz aus einer Netzwechselspannung (Ur, Us, Ut) mit vorgegebener Wechselfrequenz, umfassend: einen Gleichrichter (16) als eine erste Komponente, einen Zwischenkreis (18) als eine zweite Komponente und einen Wechselrichter (22) als eine dritte Komponente, wobei der Gleichrichter (16) als auch der Wechselrichter (18) jeweils Halbleiter-Leistungsschalter (S16, S22) aufweisen, und wobei der Gleichnichter (16) als auch der Weschselrichter (18) jeweils Halbleiter - Leistungsschalter (S16, S22) aufweisen, und wobei mittels des Gleichrichters (16) aus der Netzwechselspannung eine Zwischenkreis-Gleichspannung (Uzk) und mittels des Wechselrichters (22) aus der Zwischenkreis-Gleichspannung (Uzk) die Wechselspannung mit der vorgebbaren Wechselfrequenz erzeugbar ist, wobei wenigstens eine der Komponenten (16,18,22) eine Messeinrichtung (50,60) zum Messen einer Stromstärke eines Gleichtaktstromes aufweist, **gekennzeichnet durch** eine Auswerteeinrichtung (54,62) zum Auswerten eines Signals wenigstens einer Messeinrichtung (50,60) der genannten Art, wobei die Auswerteeinrichtung (54,62) hierzu mit der wenigstens einen Messeinrichtung (50,60) gekoppelt ist, sowie
a) eine Steuereinrichtung (C16,C22) zum Steuern der Halbleiter-Leistuggsschaltern (S16, S22) und gekoppelt mit der Auswerteeinrichtung, und/oder
b) eine Spannungsmesseinrichtung zum Messen eines Verlaufs (70) der von dem Wechselrichter (22) erzeugten Wechselspannung zum Erkennen von Schaltzeitpunkten der Halbleiter-Leistungsschalter (S16, S22), wobei die Spannungsmesseinrichtung kapazitiv mit einer Leitungseinrichung (24) für die Wechselspannung gekoppelt ist,
wobei der Frequenzumrichter angepaßt ist,
ein Schaltsignal für die Halbleiter-Leistungsschalter (S16, S22) des Frequenzumrichters (10) zu überwachen und abhängig von dem überwachten Schaltsignal wenigstens ein Zeitabschnitt des ermittelten Verlaufs (70, 74) der Stromstärke des über den Frequenzumrichter geführten Stromes auf ein vorgegebenes Kriterium hin zu untersuchen.

8. Frequenzumrichter (10) nach Anspruch 7, **dadurch gekennzeichnet, dass** die Messeinrichtung (50, 60) einen weichmagnetischen Ringkern (50,60) umfasst.

9. Frequenzumrichter (10) nach Anspruch 7 oder 8, **da** - **durch gekennzeichnet** , dass der Gleichrichter (16) eine Messeinrichtung (50) der genannten Art aufweist und hierbei ein Stromwandler (50) der Messeinrichtung zwischen einem Netzwechselspannungseingang (52) und Halbleiter-Leistungsschaltern (S16) des Gleichrichters (16) mit einer Leitungseinrichtung (36) für die Netzwechselspannung (Ur,Us,Ut) gekoppelt ist.

10. Frequenzumrichter (10) nach einem der Ansprüche 8 oder 9, **dadurch gekennzeichnet, dass** der Wechselrichter (22) eine Messeinrichtung (60) der genannten Art aufweist und hierbei mittels eines Stromwandlers (60) der Messeinrichtung (60) ein Gleichtaktstrom mit einer Leitungseinrichtung (24) für die Wechselspannung gekoppelt ist.

11. Frequenzumrichter (10) nach einem der Ansprüche 7 bis 10, **gekennzeichnet durch** einen Fehlerstromschutzschalter (26), welcher dem Gleichrichter (16) netzseitig vorgeschaltet ist und welcher **durch** eine Bandbegrenzung ein niederfrequentes Auslösespektrum aufweist und welcher hierdurch nur bei Fehlerströmen (80) mit einer Wechselfrequenz von weniger als 150 Hz, insbesondere weniger als 100 Hz, auslöst.

12. Frequenzumrichter (10) nach Anspruch 11, **gekenn** - **zeichnet** durch ein ableitstromarmes EMV-Filter (28), welches dem Gleichrichter (16) netzseitig vorgeschaltet ist und welches im bestimmungsgemäßen Betrieb des Frequenzumrichters (10) einen betriebsmäßigen Ableitstrom aufweist, welcher kleiner als eine Auslösestromstärke des Fehlerstromschutzschalters (26) ist.

## Claims

1. Method for identifying and if necessary blocking a fault current in a frequency converter (10), having the steps:
- determining a curve (70, 74, 78) of a current strength of a current conducted by way of the frequency converter (10);
- for the determined curve (70, 74, 78), predefining a signal portion (76, 80), which, during fault-free operation of the frequency converter, is independent of switching processes within the frequency converter,
- checking whether the determined curve (70, 74, 78) fulfils a criterion predetermined as a function of the signal portion (76, 80) and if necessary interrupting the current,
**characterised in that** a switching signal for semiconductor circuit breakers (S16, S22) of the frequency converter (10) is monitored and irrespective of the monitored switching signal at least one time segment of the determined curve (70, 74) of the current strength is checked in respect of the criterion.

2. Method according to claim 1, **characterised in that** the curve (70, 74, 78) of a current strength of a differential current is determined between at least two phase conductors (24, 36) of the frequency converter (10).

3. Method according to claim 1 or 2, **characterised in that** at least one spectral band is predetermined as a signal portion (76, 80).

4. Method according to one of the preceding claims, **characterised in that** at least one time segment is predetermined as a signal portion.

5. Method according to one of the preceding claims, **characterised in that,** in order to interrupt the current, pulses of an inverter (22), by way of which the fault current flows, are suppressed.

6. Method according to one of the preceding claims, **characterised in that** in order to interrupt the current, the frequency converter (10) is decoupled from a supply network (12), which forms the source of the current.

7. Frequency converter (10) for generating an AC voltage with a predeterminable alternating frequency from a mains voltage (Ur, Us, Ut) with a predeterminable alternating frequency, comprising:
a rectifier (16) as a first component, an intermediate circuit (18) as a second component and an inverter (22) as a third component, wherein the rectifier (16) and the inverter (18) each have semiconductor circuit breakers (S16, S22), and wherein an intermediate DC voltage (Uzk) can be generated from the mains voltage by means of the rectifier (16) and the AC voltage with the predeterminable alternating frequency can be generated from the intermediate DC voltage (Uzk) by means of the inverter (22), wherein at least one of the components (16, 18, 22) has a measuring facility (50, 60) for measuring a current strength of a common mode current, **characterised by** an evaluation facility (54, 62) for evaluating a signal of at least one measuring facility (50, 60) of said type, wherein the evaluation facility (54, 62) is to this end coupled to the at least one measuring facility (50, 60), and
a) a control facility (C16, C22) for controlling the semiconductor circuit breakers (S16, S22) and coupled to the evaluation unit, and/or
b) a voltage measuring facility for measuring a curve (70) of the AC voltage generated by the inverter (22) for identifying switching time points of the semiconductor circuit breakers (S16, S22), wherein the voltage measuring facility is capacitively coupled to a conducting facility (24) for the AC voltage,
wherein the frequency converter is adapted to monitor a switching signal for the semiconductor circuit breakers (S16, S22) of the frequency converter (10) and as a function of the monitored switching signal at least one time segment of the determined curve (70, 74) of the current strength of the current routed via the frequency converter is checked in respect of a predetermined criterion.

8. Frequency converter (10) according to claim 7, **characterised in that** the measuring facility (50, 60) includes a soft magnetic ring core (50, 60).

9. Frequency converter (10) according to claim 7 or 8, **characterised in that** the rectifier (16) has a measuring facility (50) of the said type and a transformer (50) of the measuring facility is coupled to a conducting facility (36) for the mains voltage (Ur, Us, Ut) between a mains voltage input (52) and semiconductor circuit breakers (S16) of the rectifier (16).

10. Frequency converter (10) according to one of claims 8 or 9, **characterised in that** the inverter (22) comprises a measuring facility (60) of the said type and a common mode current is herewith coupled to a conducting facility (24) for the AC voltage by means of a transformer (60) of the measuring facility (60).

11. Frequency converter (10) according to one of claims 7 to 10, **characterised by** a ground fault interrupter (26), which is arranged upstream of the rectifier (16) on the mains side and which thanks to band restriction has a low frequency trip spectrum and which hereby only trips with fault currents (80) having an alternating frequency of less than 150 Hz, in particular less than 100 Hz.

12. Frequency converter (10) according to claim 11, **characterised by** a low leakage current EMC filter (28), which is arranged upstream of the rectifier (16) on the mains side, and which during normal operation of the frequency converter (10) has an operational leakage current which is smaller than a trip current strength of the ground fault interrupter (26).

## Revendications

1. Procédé de détection, et le cas échéant de blocage, d'un courant de fuite dans un convertisseur ( 10 ) de fréquence, comprenant les stades :
- détermination d'une courbe ( 70, 74, 78 ) d'une intensité d'un courant passant par le convertisseur ( 10 ) de fréquence,
- pour la courbe ( 70, 74, 78 ) déterminée, prescription d'une proportion ( 76, 80 ) de signal, qui, en fonctionnement sans fuite du convertisseur de fréquence, est indépendante d'opérations de commutation au sein du convertisseur de fréquence,
- contrôle du point de savoir si la courbe ( 70, 74, 78 ) déterminée satisfait à un critère donné à l'avance en fonction de la proportion ( 76, 80 ) du signal et, le cas échéant, interruption du courant,
**caractérisé en ce qu'**on contrôle un signal de disjonction pour des disjoncteurs ( S16, S22 ) à semiconducteur du convertisseur ( 10 ) de fréquence et, en fonction du signal de disjonction contrôlé, on recherche le critère pendant au moins un segment de temps de la courbe ( 70, 74 ) déterminée de l'intensité du courant.

2. Procédé suivant la revendication 1, **caractérisé en ce qu'**on détermine la courbe ( 70, 74, 78 ) d'une intensité d'un courant différentiel entre au moins deux conducteurs ( 24, 36 ) de phase du convertisseur ( 10 ) de fréquence.

3. Procédé suivant la revendication 1 ou 2, **caractérisé en ce qu'**on prescrit au moins une bande spectrale comme proportion ( 76, 80 ) du signal.

4. Procédé suivant l'une des revendications précédentes, **caractérisé en ce qu'**on prescrit au moins un segment de temps comme proportion du signal.

5. Procédé suivant l'une des revendications précédentes, **caractérisé en ce que**, pour interrompre le courant, on supprime des impulsions d'un onduleur ( 22 ), par lequel passe le courant de fuite.

6. Procédé suivant l'une des revendications précédentes, **caractérisé en ce que**, pour interrompre le courant, on découple le convertisseur ( 10 ) de fréquence d'un réseau ( 12 ) d'alimentation, qui forme la source du courant.

7. Convertisseur ( 10 ) de fréquence pour la production d'une tension alternative d'une fréquence alternative pouvant être donnée à l'avance à partir d'une tension ( Ur, Us, Ut ) alternative du secteur d'une fréquence alternative donnée à l'avance, comprenant :
un redresseur ( 16 ) comme premier composant, un circuit ( 18 ) intermédiaire comme deuxième composant et un onduleur ( 22 ) comme troisième composant, le redresseur ( 16 ) ayant, tout comme l'onduleur ( 18 ), respectivement des disjoncteurs ( S16, S22 ) à semiconducteur, dans lequel, au moyen du redresseur ( 16 ), on peut produire, à partir de la tension alternative du secteur, une tension ( Uzk ) continue de circuit intermédiaire et, au moyen de l'onduleur ( 22 ), à partir de la tension ( Uzk ) continue du circuit intermédiaire, la tension alternative ayant la fréquence alternative pouvant être donnée à l'avance, dans lequel au moins l'un des composants ( 16, 18, 22 ) a un dispositif ( 50, 60 ) de mesure pour mesurer une intensité d'un courant de mode commun, **caractérisé par**
un dispositif ( 54, 62 ) d'exploitation pour l'exploitation d'un signal d'au moins un dispositif ( 50, 60 ) de mesure du type mentionné, le dispositif ( 54, 62 ) d'exploitation étant à cet effet relié au au moins un dispositif ( 50, 60 ) de mesure, ainsi que
a ) un dispositif ( C16, C22 ) de commande pour la commande des disjoncteurs ( S16, S22 ) à semiconducteur est relié au dispositif d'exploitation et/ou
b ) un dispositif de mesure de la tension pour la mesure d'une courbe ( 70 ) de la tension alternative produite par l'onduleur ( 22 ) pour la détection d'instant de disjonction des disjoncteurs ( S16, S22 ) à semiconducteur, le dispositif de mesure de la tension étant relié capacitivement à un dispositif ( 24 ) de conduction pour la tension alternative,
le convertisseur de fréquence étant adapté pour contrôler un signal de disjonction des disjoncteurs ( S16, S22 ) à semiconducteur du convertisseur ( 10 ) de fréquence et, pour,
en fonction du signal de disjonction contrôlé, rechercher un critère donné à l'avance pendant au moins un segment de temps de la courbe ( 70, 74 ) déterminée de l'intensité du courant qui passe par le convertisseur de fréquence.

8. Convertisseur ( 10 ) de fréquence suivant la revendication 7, **caractérisé en ce que** le dispositif ( 50, 60 ) de mesure comprend un noyau ( 50, 60 ) toroïdal à magnétisme doux.

9. Convertisseur ( 10 ) de fréquence suivant la revendication 7 ou 8, **caractérisé en ce que** le redresseur ( 16 ) a un dispositif ( 50 ) de mesure du type mentionné et ainsi un convertisseur ( 50 ) de courant du dispositif de mesure est relié, entre une entrée ( 52 ) de tension alternative du secteur et des disjoncteurs ( S16 ) à semiconducteur du redresseur ( 16 ), à un dispositif ( 36 ) de conduction pour la tension ( Ur, Us, Ut ) alternative du secteur.

10. Convertisseur ( 10 ) de fréquence suivant l'une des revendications 8 ou 9, **caractérisé en ce que** l'onduleur ( 22 ) a un dispositif ( 60 ) de mesure du type mentionné et ainsi, au moyen d'un convertisseur ( 60 ) de courant du dispositif ( 60 ) de mesure, un courant en mode commun est appliqué à un dispositif ( 24 ) de conduction pour la tension alternative.

11. Convertisseur ( 10 ) de fréquence suivant l'une des revendications 7 à 10, **caractérisé par** un interrupteur ( 26 ) de protection vis-à-vis d'un courant de fuite, qui est monté en amont du redresseur ( 16 ) du côté du secteur et qui a, par une limitation de bande, un spectre de déclenchement à basse fréquence et qui ainsi ne déclenche qu'à des courants ( 80 ) de fuite ayant une fréquence alternative de moins de 150 Hz, notamment de moins de 100 Hz.

12. Convertisseur ( 10 ) de fréquence suivant la revendication 11, **caractérisé par** un filtre ( 28 ) de compatibilité électromagnétique à peu de courant de fuite, qui est monté en amont du redresseur ( 16 ) de courant du côté du secteur et qui, lorsque le convertisseur ( 10 ) de fréquence fonctionne correctement, a un courant de fuite conforme au bon fonctionnement, qui est plus petit qu'une intensité du courant de déclenchement de l'interrupteur ( 26 ) de protection vis-à-vis d'un courant de fuite.
